# EUROPEAN PATENT APPLICATION

(11) **EP 4 345 937 A1**
(43) Date of publication of application: **03.04.2024**
(21) Application number: 23200237.8
(22) Date of filing: 27.09.2023
(51) Int. Cl.: H01M 4/131, H01M 4/36, H01M 4/525, H01M 10/0525, H01M 4/02

(54) **POSITIVE ELECTRODE MATERIAL, POSITIVE ELECTRODE AND SECONDARY BATTERY**

(30) Priority: 30.09.2022 KR 20220125334
(71) Applicant: LG Energy Solution, Ltd., Seoul 07335 (KR)
(72) Inventor: BAEK, Sora, 34122 DAEJEON (KR); KIM, Minsoo, 34122 DAEJEON (KR); KIM, Shulkee, 34122 DAEJEON (KR); PARK, Kyutae, 34122 DAEJEON (KR); PIAO, Lilin, 34122 DAEJEON (KR); YOO, Kwang Ho, 34122 DAEJEON (KR); LEE, Gyeongseop, 34122 DAEJEON (KR); JUNG, Wonhee, 34122 DAEJEON (KR)
(74) Representative: Plasseraud IP

(57) **Abstract**

Disclosed (or Provided) are a positive electrode material comprising: a first positive electrode active material which is in the form of single particles and has a coating layer including boron (B) and cobalt (Co) provided on at least a portion of the surface thereof; and a second positive electrode active material which has a lager particle diameter than that of the first positive electrode active material, is in the form of single particles and has a coating layer including boron (B) and cobalt (Co) provided on at least a portion of the surface thereof, and a positive electrode and a secondary battery including the same.

## Description

### TECHNICAL FIELD

The present invention relates to a positive electrode material, a positive electrode and a secondary battery.

### BACKGROUND ART

Secondary batteries are universally applied not only to portable devices but also to electric vehicles (EVs) and hybrid electric vehicles (HEVs), which are driven by electric driving sources.

Since such a secondary battery has not only the primary advantage of being able to dramatically reduce the use of fossil fuels, but also the advantage of not generating any by-products caused by the use of energy, the secondary battery is attracting attention as a new energy source that is environmentally friendly and improves energy efficiency.

In general, a secondary battery includes a positive electrode, a negative electrode, a separator interposed between the positive electrode and the negative electrode, and an electrolyte. Further, an electrode such as a positive electrode and a negative electrode may comprise an electrode active material layer provided on a current collector.

As the use of secondary batteries increases, different battery performance characteristics are required. For example, attempts have been made to apply a silicon-based active material to the negative electrode in order to develop a high-capacity battery, but the silicon-based active material has a problem in that the initial irreversibility is high. Although attempts have been made to adjust the components of the positive or negative electrode or to add additives in order to improve battery performance or the sustainability, the selection or combination of wrong materials may adversely affect the performance or the sustainability of a final battery. Therefore, there is a need for research on maintaining or improving the performance of a secondary battery while maintaining or improving the sustainability thereof according to the selection or combination of materials for the positive electrode or the negative electrode.

### SUMMARY OF THE INVENTION

The present invention refers to a positive electrode material, which can provide the irreversible capacity of a negative electrode when used with the negative electrode using a silicon-based active material, can prevent the cycle performance deterioration problem by reducing the resistance difference with the negative electrode, and can implement a high-density electrode, a positive electrode, and a secondary battery including the same.

An embodiment of the present invention provides a positive electrode material comprising: a first positive electrode active material which is in the form of single particles and has a coating layer including cobalt (Co) and boron (B) provided on at least a portion of the surface of the single particles presenting a diameter D1; and a second positive electrode active material which is in the form of single particles presenting a diameter D2, with D2>D1 and has a coating layer including cobalt (Co) and boron (B) provided on at least a portion of the surface of the single particles.

Another embodiment of the present invention provides a positive electrode for a secondary battery, including a current collector; and a positive electrode active material layer provided on the current collector and including the positive electrode material according to the above-described embodiment.

Still another embodiment of the present invention provides a secondary battery including the positive electrode, the negative electrode, and the separator according to the above-described embodiments.

According to yet another embodiment of the present invention, the negative electrode includes a silicon-based active material.

Another embodiment of the present invention provides a method for preparing the positive electrode material, the method comprises a step of preparing a first positive electrode active material which includes forming a first positive electrode active material in the form of single particles by mixing a transition metal precursor and a lithium raw material, and then firing the resulting mixture, an optional step of washing the positive electrode active material with water, and a step of forming a coating layer comprising cobalt (Co) and boron (B) on at least a portion of the surface of the positive electrode active material, a step of preparing a second positive electrode active material which comprises forming a second positive electrode active material in the form of single particles having a larger particle diameter than that of the single particles of the first positive electrode active material by mixing a transition metal precursor and a lithium raw material, and then firing the resulting mixture, an optional step of washing the positive electrode active material with water, a step of forming a coating layer including cobalt (Co) and boron (B) on at least a portion of the surface of the positive electrode active material, and a step of mixing the first positive electrode active material and the second positive electrode active material.

According to yet another embodiment of the present invention, the forming a coating layer comprising cobalt (Co) and boron (B) on at least a portion of the surface of the positive electrode active material may comprise forming the coating layer comprising cobalt (Co) and then forming the coating layer comprising boron (B).

According to embodiments described in the present invention, by using, as positive electrode active materials, both a first positive electrode active material and a second positive electrode active material, which have different particle diameters and are in the form of single particles, a high-density electrode can be implemented and low-efficiency characteristics are possessed, so that it is possible to provide the irreversible capacity of a negative electrode using a silicon-based active material when the positive electrode active materials are used with the negative electrode. Further, the usable voltage of the silicon-based active material of the negative electrode can be reduced to significantly improve the room temperature service life by applying a boron coating layer to both first and second positive electrode active materials having different particle diameters to increase the interfacial resistance of the positive electrode, thereby improving a rapid decrease in discharge end resistance. In addition, when a cobalt coating layer is formed on the first and second positive materials before forming a boron coating layer, cobalt and boron are simultaneously present in the coating layer, so that the positive electrode resistance can be improved by the cobalt and a rapid decrease in resistance of the discharge end resistance can be improved by the boron.

### DETAILED DESCRIPTION

Hereinafter, the present invention will be described in more detail in order to help the understanding of the present invention. The present invention can be implemented in various different forms, and is not limited to the embodiments described herein. In this case, terms or words used in the specification and the claims should not be interpreted as being limited to typical or dictionary meanings and should be interpreted with a meaning and a concept that are consistent with the technical spirit of the present invention based on the principle that an inventor can appropriately define a concept of a term in order to describe his/her own invention in the best way.

In the present invention, the term "comprise", "include", or "have" is intended to indicate the presence of the characteristic, number, step, constituent element, or any combination thereof implemented, and should be understood to mean that the presence or addition possibility of one or more other characteristics or numbers, steps, constituent elements, or any combination thereof is not precluded.

When the term "about" is used, it may be referred to a value which may vary for example, ±10% of defined value, ±5% of the defined value, ±1% of the defined value, or ±0.1% of the defined value.

A case where a part such as a layer is present "above" or "on" another part includes not only a case where the part is present "immediately above" another part, but also a case where still another part is present therebetween. Conversely, the case where a part is present "immediately above" another part means that no other part is present therebetween. In addition, a case of being "above" or "on" a reference part means being located above or below the reference part, and does not necessarily mean being located "above" or "on" in the opposite direction of gravity.

In the present specification, particle diameter means the average particle diameter represented by D50. D50 means the particle size on the basis of 50% of the volume cumulative particle size distribution of the positive electrode active material powder. The average particle diameter D50 may be measured using a laser diffraction method. For example, after a positive electrode active material powder is dispersed in a dispersion medium, the resulting dispersion is introduced into a commercially available laser diffraction particle size measuring device (for example, Microtrac MT 3000) to irradiate the dispersion with an ultrasonic wave of 28 kHz with an output of 60 W, then a volume cumulative particle size distribution graph is obtained, and then the average particle diameter may be measured by obtaining the particle size corresponding to 50% of the volume cumulative amount.

In the present specification, the "primary particles" means particles having no grain boundaries in appearance when observed at a magnification of 5,000 times to 20,000 times using a scanning electron microscope. The "average particle diameter of primary particles" means the arithmetic mean value of particle diameters calculated after measuring the particle diameters of primary particles observed in a scanning electron microscope image.
In the present specification, the "secondary particles" are particles formed by aggregation of a plurality of primary particles.

In the present specification, the "single particle is a term used to distinguish single particles from positive electrode active material particles in the form of secondary particles formed by aggregation of tens to hundreds of primary particles generally used in the related art, and is a concept including a single particle composed of one primary particle and aggregate particles of 10 or less primary particles.

In the present specification, the "particles" may be meant to include any or all of single particles, secondary particles, and primary particles.

In the present specification, the "specific surface area" is measured by the BET method, and may be specifically calculated from an amount of nitrogen gas adsorbed under liquid nitrogen temperature (77K) using BELSORP-mino II manufactured by BEL Japan, Inc.

In the present specification, the content of each component of the positive electrode active material may be measured by inductively coupled plasma mass spectrometry (ICP). Specifically, a sample to be measured was pre-treated using acid, and then measured using an ICP-OES (Perkin Elmer, Optima 7300DV) device.

A positive electrode material according to an embodiment of the present specification is characterized by including: a first positive electrode active material which is in the form of single particles presenting an average particle diameter (D50) D1 and has a coating layer including cobalt (Co) and boron (B) provided on at least a portion of the surface of the single particles; and a second positive electrode active material which is in the form of single particles presenting an average particle diameter (D50) D2, with D2 > D1 and has a coating layer including cobalt (Co) and boron (B) provided on at least a portion of the surface of the single particles. According to the embodiment, by using two types of single particles having different average particle diameters as the positive electrode active material, the gaps between the positive electrode active material particles having a large particle diameter are filled with positive electrode active material particles having a small particle diameter to enhance the electrode density, and the contact area between the positive electrode active material particles is increased, so that the effect of improving the energy density can be obtained. Having the single particles used, the electrode may have low-efficiency characteristics, thereby the negative electrode which is a silicon-based active material may provide the irreversible capacity. Furthermore, a rapid decrease in discharge end resistance may be improved by applying a coating layer including boron and cobalt to both the first and second positive electrode active materials to increase the interfacial resistance of the positive electrode.

According to an embodiment, the discharge end resistance of a battery utilizing the positive electrode active material of the present disclosure may be within a range of 2.6 Ω or more, for example 2.65 Ω or more and within a range of 4 Ω or less, for example 3.5 Ω or less. It is preferable that the room temperature service life measured by the method described in the examples is 90% or more, for example, may be 91% or more, 92% or more, 93% or more, 94% or more, 95% or more, 97% or more, or 98% or more. It is preferable that the high temperature service life measured by the method described in the examples is each 87% or more, for example, 88% or more, 90% or more, 92% or more, 93% or more, 94% or more, 95% or more, or 97% or more.

According to an embodiment, the first positive electrode active material may have a D50 of 1 um or more and 7 um or less, and specifically may have a D50 of 1 um or more, 2 um or more, or 3 um or more, and 7 um or less, 6 um or less, 5 um or less, or 4 um or less.

According to another embodiment, the second positive electrode active material may have a D50 of 3 um or more and 12 um or less, specifically may have a D50 of 3 um or more, 4 um or more, or 5 um or more, and 12 um or less, 11 um or less, 10 um or less, 9 um or less, 8 um or less, or 7 um or less.

According to one embodiment, the second positive electrode active material may have the average particle diameter D2 larger than the average particle diameter D1 of the first positive electrode active material such that the difference D2-D1 is 0.5 um to 7 µm, for example, 0.8 um to 5 um, or 1 um to 4 um. When the difference in particle diameter D2-D1 is less than 0.5 um, the thickness of the coated electrode increases due to a decrease in tap density (g/cc) of the positive electrode active material, which may result in poor rolling characteristics during the rolling of the electrode, and when the difference in particle diameter D2-D1 exceeds 7 µm, the imbalance between the two particles during the electrochemical reaction may increase due to the increase in the specific surface area difference.

According to an embodiment, the weight ratio of the first positive electrode active material and the second positive electrode active material may be 1:9 to 9:1, for example, 3:7 to 7:3, specifically 4:6 to 6:4, or 5:5. The closer the weight ratio of the first positive electrode active material and the second positive electrode active material, the better the electrode density.

According to an embodiment, each of the first positive electrode active material and the second positive electrode active material may include a lithium-nickel-based oxide in which the mole fraction of nickel in the metal elements except for lithium is 50 mol% or more. The first and second positive electrode active materials may have the same composition and may differ only in average particle diameter, or may also differ in both composition and average particle diameter.

The lithium-nickel-based oxide may be a lithium-nickel-cobalt-manganese-based oxide in which the mole fraction of nickel in the metal elements except for lithium is 50 to 99 mol%, for example, 60 to 99 mol%, and specifically 80 to 98 mol%.

According to an embodiment, the lithium-nickel-based oxide may have a composition represented by the following [Chemical Formula 1].

[Chemical Formula 1] Li₁₊ₓ(NiₐCo_{b}Mn_{c}M_{d})O₂

In Chemical Formula 1,
M is one or more selected from the group consisting of W, Cu, Fe, V, Cr, Ti, Zr, Zn, Al, In, Ta, Y, La, Sr, Ga, Sc, Gd, Sm, Ca, Ce, Nb, Mg, B and Mo, and
x, a, b, c and d are 0≤x≤0.2, 0.50≤a<1, 0<b≤0.25, 0<c≤0.25, 0≤d≤0.1, and a+b+c+d=1, respectively.

In [Chemical Formula 1], M is one or more selected from the group consisting of W, Cu, Fe, V, Cr, Ti, Zr, Zn, Al, In, Ta, Y, La, Sr, Ga, Sc, Gd, Sm, Ca, Ce, Nb, Mg, B and Mo, may be preferably one or more selected from the group consisting of Al, Zr, Y, Mg, and Ti, and may be more preferably Al or Zr. The M element is not essentially included, but may serve to promote particle growth during firing and improve crystal structure stability when included in an appropriate amount.

a represents a molar ratio of nickel among the metals except for lithium in the lithium-nickel-based oxide, and may be 0.5≤a≤0.99, 0.6≤a≤0.99, 0.7≤a≤0.98, or 0.8≤a ≤0.98.

b represents a molar ratio of cobalt among the metals except for lithium in the lithium-nickel-based oxide, and may be 0<b≤0.25, and 0.01≤b≤0.2.

c represents a molar ratio of manganese among the metals except for lithium in the lithium-nickel-based oxide, and may be 0<c≤0.25, and 0.01≤c≤0.2.

d represents a molar ratio of M element among the metals except for lithium in the lithium-nickel-based oxide, and may be 0≤d≤0.1 or 0≤d≤0.08.

Preferably, the lithium-nickel-based oxide may be a lithium-nickel-cobalt-manganese oxide doped with Zr. During doping with Zr, an effect of suppressing particle cracking during electrode rolling is even better. In this case, Zr may be included in an amount of 3,000 ppm to 6,000 ppm, preferably 3,500 ppm to 5,500 ppm, more preferably 4,000 ppm to 5,000 ppm based on the total weight of the positive electrode material. When the content of Zr satisfies the above range, service life characteristics may be improved due to excellent structural stability.

According to one embodiment, the coating layer in the first positive electrode active material comprises a coating layer comprising cobalt (Co) and a coating layer comprising boron (B). The coating layer comprising cobalt (Co) is provided on at least a portion of the surface of the first positive electrode active materials or between a coating layer comprising boron (B) and at least a portion of the surface of the first positive electrode active material.

According to one embodiment, the coating layer in the second positive electrode active material comprises a coating layer comprising cobalt (Co) and a coating layer comprising boron (B). The coating layer comprising cobalt (Co) is provided on at least a portion of the surface of the second positive electrode active materials or between a coating layer comprising boron (B) and at least a portion of the surface of the second positive electrode active material.

The above-described coating layer including boron is formed on the surface of the lithium-nickel-based oxide. In this case, the coating layer including boron may cover the entire surface of the lithium-nickel-based oxide, but is not limited thereto, and may cover only a portion of the lithium-nickel-based oxide. The coating layer including boron may be arranged continuously on the surface of the lithium-nickel-based oxide, but two or more portions thereof may be arranged spaced apart, and at least a portion thereof may be arranged in the form of islands.

When a coating layer including boron (B) is formed on the surface of the lithium-nickel-based oxide, the rapid decrease in resistance at the discharge end may be improved by increasing the interfacial resistance of the positive electrode. As a result, the difference in resistance with the negative electrode may be reduced, so that the usable voltage of the silicon-based active material of the negative electrode may be reduced, and accordingly, the deterioration in the cycle performance of the battery may be prevented and the room temperature service life may be improved. In addition, the contact between the electrolyte and the lithium-nickel-based oxide is minimized by the coating layer including boron, so that the occurrence of side reactions between the electrolyte and the lithium-nickel-based oxide and the elution of transition metals is suppressed, and as a result, an effect of improving service life characteristics may be obtained, and particle cracking during rolling is also reduced.

According to one embodiment, the boron (B) may be included in an amount of 200 ppm to 3,000 ppm, for example, 300 ppm to 2,000 ppm, 300 ppm to 1,800 ppm, 400 ppm to 1,500 ppm, or 500 ppm to 1,300 ppm based on the weight of each of the first and second positive electrode active materials. When the content of boron (B) is less than 200 ppm based on the weight of each of the first and second positive electrode active materials, a coating layer cannot be sufficiently formed on the surface of the positive electrode active material, so that the interfacial resistance of the positive electrode cannot be increased, and when the content of boron (B) exceeds 3,000 ppm, the surface of the positive electrode active material may be entirely covered with a coating layer to prevent the electrochemical reaction from occurring properly.

According to an embodiment, the content of boron in the first positive electrode active material may be higher than the content of boron in the second positive electrode active material. Since the first positive electrode active material, which has a relatively smaller particle diameter, has a larger specific surface area than the second positive electrode active material, side reactions with the electrolyte solution may be effectively controlled such that the content of boron is higher than that of the second positive electrode active material. By suppressing the side reaction with the electrolyte solution as described above, the resistance characteristics and high-temperature service life may be improved.

According to an embodiment, the weight ratio (A/B) of the content A of boron in the first positive electrode active material and the content B of boron in the second positive electrode active material may be 1 to 3, for example, 1.5 to 3, or 1 to 2.5, and specifically 1.5 to 2.5 or 1.5 to 2. For example, based on the weight of the first positive electrode active material, the content of boron (B) in the first positive electrode active material may be 600 ppm to 3,000 ppm, for example, 700 ppm to 1,500 ppm. For example, based on the weight of the second positive electrode active material, the content of boron (B) in the second positive electrode active material may be 200 ppm to 1,000 ppm, for example, 300 ppm to 700 ppm, or 400 ppm to 650 ppm.

According to one embodiment, the first and second positive electrode active materials may include a coating layer including cobalt (Co) provided on at least a portion of the surface or between a coating layer including boron (B) and at least a portion of the surface of the single particle. In this case, the coating layer including cobalt may cover the entire surface of the lithium-nickel-based oxide, but is not limited thereto, and may cover only a portion of the lithium-nickel-based oxide. The coating layer including cobalt may be arranged continuously with each other on the surface of the lithium-nickel-based oxide, but two or more portions thereof may be arranged spaced apart, and at least a portion thereof may be arranged in the form of islands. When a coating layer including cobalt is applied, the coating layer including boron may also be provided on the coating layer including cobalt and may also be provided directly in contact with the surface of a lithium-nickel-based oxide where the coating layer including cobalt is not present. In one embodiment, there may be no intervening layers between the boron coating layer and the lithium-nickel-based oxide, aside from the cobalt coating layer. The positive electrode resistance may be improved by applying a coating layer including cobalt. However, when a coating layer including cobalt is applied, the discharge end resistance is significantly improved, so that the usable voltage of the silicon-based active material included in the negative electrode increases, which may lead to deterioration in the cycle characteristics, but in the embodiments described in the present specification, the presence of the coating layer including boron can increase the interfacial resistance of the positive electrode, thereby reducing the rapid decrease in discharge end resistance.

The cobalt included in the coating layer including cobalt (Co) may be included in an amount of 5,000 ppm to 50,000 ppm, for example, 5,000 ppm to 30,000 ppm, 10,000 ppm to 30,000 ppm, 15,000 ppm to 25,000 ppm, or 17,000 ppm to 23,000 ppm based on the weight of the first positive electrode active material.

The cobalt included in the coating layer including cobalt may be included in an amount of 5,000 ppm to 50,000 ppm, for example, 5,000 ppm to 30,000 ppm, 10,000 ppm to 30,000 ppm, 15,000 ppm to 25,000 ppm, or 17,000 ppm to 23,000 ppm based on the weight of the second positive electrode active material. When the cobalt (Co) content satisfies the above range, it is advantageous for improving the positive electrode resistance.

According to one embodiment, in the first positive electrode active materials, the ratio of the amount of boron to the amount of cobalt in the coating layer is 0.001 to 1, preferably 0.02 to 0.8, 0.02 to 0.7, 0.03 to 0.6, 0.04 to 0.5, 0.05 to 0.4, or 0.06 to 0.3, more preferably 0.005 to 0.175, 0.02 to 0.15, or 0.025 to 0.1.

According to one embodiment, in the second positive electrode active materials, the ratio of the amount of boron to the amount of cobalt is 0.001 to 0.5, 0.01 to 0.4, 0.02 to 0.3, 0.03 to 0.2, preferably 0.005 to 0.175, 0.02 to 0.15, or 0.025 to 0.1.

The ratio is calculated by ppm contents. When the ratio is less than 0.001, the effect of the presence of boron in the coating layer may be minimal. When the ratio exceeds 0.2, boron may be excessively contained compared to cobalt, which may negatively affect battery performance. The content of cobalt is the amount of the cobalt that constitutes the coating layer.

In some embodiments, the ratio (Co/B) of the cobalt content to the boron content contained in the entire first and second positive electrode active materials may be 5 to 70, for example 7 to 60, 20 to 55, or 25 to 50. Here, the cobalt includes cobalt contained in single particles in addition to the cobalt in the coating layer.

According to an embodiment, the first and second positive electrode active materials or the positive electrode material may have a BET specific surface area of 0.2 to 1 m²/g, preferably, 0.25 to 0.85 m²/g. When the specific surface area of the lithium-nickel-based oxide is large, side reactions with the electrolyte solution may occur frequently, resulting in deterioration of service life characteristics, and when the specific surface area of the positive electrode active material is reduced, side reactions with the electrolyte solution are reduced, so that it is possible to obtain an effect of improving service life characteristics.

An embodiment provides a method for preparing a positive electrode active material, and the method includes:
preparing a single particle positive electrode active material by mixing a transition metal precursor and a lithium raw material and then firing the resulting mixture;
washing the positive electrode active material with water; and
forming a coating layer including cobalt (Co) and boron (B) on at least a portion of the surface of the positive electrode active material.

According to one embodiment, the forming a coating layer comprising cobalt (Co) and boron (B) on at least a portion of the surface of the positive electrode active material comprises comprising forming a coating layer comprising cobalt (Co) before forming the coating layer comprising boron (B); and forming the coating layer comprising boron (B).

Another embodiment provides a method for preparing the positive electrode material according to the above-described embodiments, and the method includes:
preparing a first positive electrode active material, including: forming a first positive electrode active material in the form of single particles by mixing a transition metal precursor and a lithium raw material, and then firing the resulting mixture; washing the positive electrode active material with water; and forming a coating layer including cobalt (Co) and boron (B) on at least a portion of the surface of the positive electrode active material;
preparing a second positive electrode active material, including: forming a second positive electrode active material in the form of single particles having a larger particle diameter than that of the single particles of the first positive electrode active material by mixing a transition metal precursor and a lithium raw material, and then firing the resulting mixture; washing the positive electrode active material with water; and forming a coating layer including cobalt (Co) and boron (B) on at least a portion of the surface of the positive electrode active material; and
mixing the first positive electrode active material and the second positive electrode active material.

According to one embodiment, the forming a coating layer comprising cobalt (Co) and boron (B) on at least a portion of the surface of the positive electrode active material comprises comprising forming a coating layer comprising cobalt (Co) before forming the coating layer comprising boron (B); and forming the coating layer comprising boron (B) in the preparing of at least one of the first positive electrode active material and the second positive electrode active material.

Particle diameters of the first positive electrode active material and the second positive electrode active material may be controlled by varying the process conditions such as the firing temperature, the firing time, and the precursor synthesizing time.

A method for preparing the above-described first and second positive electrode active materials will be described.

The above-described lithium-nickel-based oxide may be prepared by mixing a transition metal precursor and a lithium raw material and then firing the resulting mixture. The precursor may be used by purchasing a commercially available precursor or may be prepared by putting an aqueous transition metal solution, an ammonium cation complex forming agent, and a basic compound into a reactor to perform a co-precipitation reaction under stirring.

For example, when an aqueous transition metal solution, an ammonium cation complex forming agent, and a basic compound are put into a reactor and stirred, precursor particles in the form of a transition metal hydroxide are produced while transition metals in the aqueous transition metal solution are co-precipitated.

In this case, the aqueous transition metal solution, the ammonium cation complex forming agent and the basic compound are added in an amount such that the pH of the reaction solution is within a desired range.

When precursor particles are formed by the method as described above, a precursor is obtained by separating the precursor particles from the reaction solution.

The aqueous transition metal solution may be prepared by dissolving a transition metal-containing raw material in a solvent such as water, and may be prepared by dissolving, for example, a nickel-containing raw material, a cobalt-containing raw material, a manganese-containing raw material and/or an aluminum-containing raw material in water.

Meanwhile, the transition metal-containing raw material may be a transition metal acetate, carbonate, nitrate, sulfate, halide, sulfide, oxide, or the like.

The nickel-containing raw material may be Ni(OH)₂, NiO, NiOOH, NiCO₃·2Ni(OH)₂· 4H₂O, NiC₂O₂·2H₂O, Ni(NO₃)₂·6H2O, NiSO₄, NiSO₄·6H₂O, a fatty acid nickel salt, a nickel halide, or the like, and any one thereof or a mixture of two or more thereof may be used.

The cobalt-containing raw material may be Co(OH)₂, CoOOH, Co(OCOCH₃)₂ · 4H₂O, Co(NO₃)₂ · 6H₂O or Co(SO₄)₂ · 7H₂O, or the like, and any one thereof or a mixture of two or more thereof may be used.

The manganese-containing raw material may be a manganese oxide such as Mn₂O₃, MnO₂, and Mn₃O₄; a manganese salt such as MnCO₃, Mn(NO₃)₂, MnSO₄, manganese acetate, dicarboxylic acid manganese salt, manganese citrate and fatty acid manganese salt; oxyhydroxide, manganese chloride, or the like, and any one thereof or a mixture of two or more thereof may be used.

If necessary, the aqueous transition metal solution may further include a doping element (M) in addition to nickel, cobalt and manganese. In this case, the M may include at least one or more selected from the group consisting of W, Cu, Fe, V, Cr, Ti, Zr, Zn, Al, In, Ta, Y, La, Sr, Ga, Sc, Gd, Sm, Ca, Ce, Nb, Mg, B and Mo. When the positive electrode active material further includes a doping element, it is possible to achieve an effect of improving service life characteristics, discharge characteristics and/or stability, and the like.

When the aqueous transition metal solution further includes the doping element M, the raw material containing the doping element M may be selectively further added during the preparation of the transition metal precursor.

At least one or more selected from the group consisting of an acetate, a sulfate, a sulfide, a hydroxide, an oxide or an oxyhydroxide including the doping element M may be used as the raw material containing the doping element M.

Meanwhile, the ammonium cation complex forming agent may be at least one or more selected from the group consisting of NH₄OH, (NH₄)₂SO₄, NH₄NO₃, NH₄Cl, CH₃COONH₄, and NH₄CO₃, and may be put into a reactor in the form of a solution in which the compound is dissolved in a solvent. As the solvent, water or a mixture of water and an organic solvent (specifically, alcohol or the like) that can be uniformly mixed with water may be used.

Next, the basic compound may be at least one or more selected from the group consisting of NaOH, KOH, and Ca(OH)₂, and may be put into a reactor in the form of a solution in which the compound is dissolved in a solvent. In this case, as the solvent, water or a mixture of water and an organic solvent (specifically, alcohol or the like) that can be uniformly mixed with water may be used.

As the lithium raw material, lithium-containing sulfates, nitrates, acetates, carbonates, oxalates, citrates, halides, hydroxides, oxyhydroxides, and the like can be used, and for example, Li₂CO₃, LiNO₃, LiNO₂, LiOH, LiOH · H₂O, LiH, LiF, LiCl, LiBr, LiI, CH₃COOLi, Li₂O, Li₂SO₄, CH₃COOLi, Li₃C₆H₅O₇ or a mixture thereof may be used.

The precursor and the lithium raw material may be mixed such that the molar ratio of a transition metal (Me):lithium (Li) included in the precursor is 1:1 to 1:1.2, preferably 1:1 to 1:1.1. When the lithium raw material is mixed in less than the above range, there is a risk in that the capacity of a positive electrode active material to be prepared is reduced, and when the lithium raw material is mixed in excess of the above range, the particles may be sintered during the firing process, making it difficult to prepare the positive electrode active material, and a decrease in capacity and the separation of the positive electrode active material particles after firing may occur.

An M-containing material may be additionally mixed during the firing, if necessary. The doping element M may be at least one or more selected from the group consisting of, for example, W, Cu, Fe, V, Cr, Ti, Zr, Zn, Al, In, Ta, Y, La, Sr, Ga, Sc, Gd, Sm, Ca, Ce, Nb, Mg, B and Mo, and the raw material containing the doping element M may be at least one selected from the group consisting of acetates, sulfates, sulfides, hydroxides, oxides or oxyhydroxides including the doping element M.

The firing may be performed at 700°C to 1,000°C for 10 hours to 35 hours, preferably at 750°C to 900°C for 15 hours to 30 hours, but is not limited thereto.

Subsequently, washing the fired, uncoated positive electrode active material with water is performed. It is preferable that the washing with water is performed so as to remove about 30 wt% or more, 40 wt% or more, or 50 wt% or more of the residual lithium by-product content in the positive electrode active material. For example, when the residual lithium by-product content in the positive electrode active material before the washing with water is 1 wt%, the residual lithium by-product content in the washed positive electrode active material may be 0.5 wt%. Here, the residual lithium by-product means compounds containing lithium, such as LiOH, Li₂CO₃. Washing can be performed under conditions that can reach the content of residual lithium by-products as described above. The washing with water may be performed by mixing the fired positive electrode active material with water and stirring the resulting mixture. In this case, the weight ratio of the positive electrode active material and water may be 7:3 to 3:7, for example, 5:5, and the water washing time may be determined, if necessary, and may be, for example, 3 minutes or more or 5 minutes. The washing conditions, including the time, temperature, and weight ratio of active material to water, may be carefully selected in order to achieve an appropriate reduction in residual lithium content.

Next, the lithium-nickel-based oxide and the boron-containing coating raw material are mixed and then heat-treated to form a coating layer.

The boron-containing coating raw material may be, for example, H₂BO₃, HBO₂, H₃BO₃, H₂B₄O₇, B₂O₃, C₆H₅B(OH)₂, (C₆H₅O)₃B, (CH₃(CH₂)₃0)₃B, C₃H₉B₃O₆, (C₃H₇O₃)B, and the like. The coating raw material is mixed in an amount such that the content of boron (B) is 200 ppm to 3,000 ppm based on the total weight of each positive electrode active material.

Meanwhile, the mixing of the lithium-nickel-based oxide and the coating raw materials may be performed by solid-phase mixing, and the heat treatment may be performed at a temperature of 200°C to 500°C or 250°C to 400°C, but is not limited thereto.

If necessary, a coating layer including cobalt may be formed before forming the coating layer including boron. The same method as the method for forming the coating layer including boron can be used, except that the above-described cobalt-containing coating raw material is used. The cobalt-containing raw material may be one or more selected from the group consisting of Co₃O₄, Co(OH)₂, Co₂O₃, Co₃(PO₄)₂, CoF₃, Co(OCOCH₃)₂·4H₂O, Co(NO₃)·6H₂O, Co(SO₄)₂·7H₂O and CoC₂O₄. In this case, it is preferred that the cobalt-containing coating raw material is mixed in an amount such that the content of cobalt is 5,000 ppm to 50,000 ppm based on the weight of each positive electrode active material.

Meanwhile, the positive electrode material of the present invention may be prepared by a method of preparing each of the first positive electrode active material and the second positive electrode active material, then mixing the positive electrode active materials to form a mixture, mixing the mixture with a cobalt-containing coating raw material or a boron-containing coating raw material, and then performing a heat treatment to form coating layers on the surfaces of the first and second positive electrode active materials.

According to an embodiment, the positive electrode active material having the boron-containing coating layer and/or the cobalt-containing coating layer has a residual lithium by-product content of 1 wt% or less, preferably 0.8 wt% or less, 0.7 wt% or less, 0.6 wt% or less, 0.55 wt% or less, 0.5 wt% or less, 0.4 wt% or less based on 100 wt% of the positive electrode active material by performing the above-described water-washing process. Residual lithium by-product may be measured by the following method. After the lithium by-product remaining on the surface of the coated positive electrode active material was dissolved by pouring 10 g of the positive electrode active material into distilled water, only the solution was filtered and titrated while injecting 0.1 M HCl at a rate of 0.3 to 0.5 mL/min. In this case, the residual lithium by-product content was calculated with the amount of HCl injected up to pH 5. The device used for pH titration is a device manufactured by Metrohm AG. The above measurement can be performed on the positive electrode active material after the above-described coating layer is formed.

An additional embodiment of the present invention provides a positive electrode for a secondary battery, including a current collector; and a positive electrode active material layer provided on the current collector and including the positive electrode material according to the above-described embodiment.

The positive electrode active material layer may additionally include a binder and a conductive material.

According to an embodiment, the positive electrode binder may serve to improve the bonding between positive electrode active material particles and the adhesion between the positive electrode active material particles and the positive electrode current collector. As the positive electrode binder, those known in the art may be used, non-limiting examples thereof include polyvinylidene fluoride (PVDF), a vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, styrene-butadiene rubber (SBR), fluorine rubber, or various copolymers thereof, and any one thereof or a mixture of two or more thereof may be used.

Yet another embodiment of the present invention, the positive electrode binder may be included in an amount of 0.1 parts by weight or more and 50 parts by weight or less, for example, preferably 0.3 parts by weight or more and 35 parts by weight or less, and more preferably 0.5 parts by weight or more and 20 parts by weight or less, based on 100 parts by weight of the positive electrode active material layer.

The conductive material included in the positive electrode active material layer is used to impart electrical conductivity to the electrode, and can be used without particular limitation as long as the conductive material has electrical conductivity without causing a chemical change in a battery. Specific examples thereof include graphite such as natural graphite or artificial graphite; a carbon-based material such as carbon black, acetylene black, Ketjen black, channel black, furnace black, lamp black, thermal black, and carbon fiber; metal powder or metal fiber such as copper, nickel, aluminum, and silver; a conductive whisker such as zinc oxide and potassium titanate; a conductive metal oxide such as titanium oxide; or a conductive polymer such as a polyphenylene derivative, and any one thereof or a mixture of two or more thereof may be used.

Specifically, in an embodiment, the conductive material may include one or more of single-walled carbon nanotube (SWCNT); and multi-walled carbon nanotube (MWCNT). The conductive material may be included in an amount of 0.1 parts by weight or more and 2 parts by weight or less, for example, preferably 0.3 parts by weight or more and 1.5 parts by weight or less, and more preferably 0.5 parts by weight or more and 1.2 parts by weight or less, based on 100 parts by weight of the composition for a positive electrode active material layer.

According to an additional embodiment of the present invention, provided is a positive electrode for a secondary battery, including a current collector; and a positive electrode active material layer provided on the current collector and including the above-described positive electrode composition. The positive electrode active material layer may have a thickness of 20 um or more and 500 um or less, 30 um or more and 400 um or less, 50 um or more and 300 um or less, 100 um or more and 200 um or less.

The positive electrode active material in 100 parts by weight of the positive electrode active material layer may be included in an amount of 80 parts by weight or more and 99.9 parts by weight or less, preferably 90 parts by weight or more and 99.9 parts by weight or less, more preferably 95 parts by weight or more and 99.9 parts by weight or less, and even more preferably 96 parts by weight or more and 99.9 parts by weight or less.

The positive electrode current collector is not particularly limited as long as the collector has electrical conductivity without causing a chemical change to a battery, and for example, it is possible to use stainless steel, aluminum, nickel, titanium, calcined carbon, or aluminum or stainless steel whose surface is treated with carbon, nickel, titanium, silver, and the like. Further, the positive electrode current collector may typically have a thickness of 1 to 500 um, and the adhesion of the positive electrode active material may also be enhanced by forming fine irregularities on the surface of the current collector. For example, the positive electrode current collector may be used in various forms such as a film, a sheet, a foil, a net, a porous body, a foam body, and a non-woven fabric body.

An additional embodiment of the present specification provides a secondary battery including the positive electrode, the negative electrode, and the separator according to the above-described embodiment.

The negative electrode may include a current collector and a negative electrode active material layer provided on the current collector.

According to an embodiment, the negative electrode includes a silicon-based active material.

The active material containing SiOₓ (0≤x<2) as the silicon-based active material may be a silicon-based composite particle including SiOₓ (0<x<2) and pores.

The SiOₓ (0<x<2) corresponds to a matrix in the silicon-based composite particle. The SiOₓ (0<x<2) may be in a form including Si and SiO₂, and the Si may also form a phase. That is, the x corresponds to the number ratio of O for Si included in the SiOₓ (0<x<2). When the silicon-based composite particles include the SiOₓ (0<x<2), the discharge capacity of a secondary battery may be improved.

The silicon-based composite particles may further include at least one of a Mg compound and a Li compound. The Mg compound and Li compound may correspond to a matrix in the silicon-based composite particle.

The Mg compound and/or Li compound may be present inside and/or on the surface of the SiOₓ (0<x<2). The initial efficiency of the battery may be improved by the Mg compound and/or Li compound.

The Mg compound may include at least any one selected from the group consisting of Mg silicates, Mg silicides and Mg oxides. The Mg silicate may include at least any one of Mg₂SiO₄ and MgSiO₃. The Mg silicide may include Mg₂Si. The Mg oxide may include MgO.

In an embodiment of the present specification, the Mg element may be included in an amount of 0.1 wt% to 20 wt%, or 0.1 wt% to 10 wt% based on total 100 wt% of the silicon-based active material. Specifically, the Mg element may be included in an amount of 0.5 wt% to 8 wt% or 0.8 wt% to 4 wt%. When the above range is satisfied, the Mg compound may be included in an appropriate content in the silicon-based active material, so that the volume change of the silicon-based active material during the charging and discharging of a battery may be readily suppressed, and the discharge capacity and initial efficiency of the battery may be improved.

The Li compound may include at least any one selected from the group consisting of Li silicates, Li silicides and Li oxides. The Li silicate may include at least any one of Li₂SiO₃, Li₄SiO₄ and Li₂Si₂O₅. The Li silicide may include Li₇Si₂. The Li oxide may include Li₂O.

In an embodiment of the present invention, the Li compound may be present in the form of a lithium silicate. The lithium silicate is represented by LiₐSi_{b}O_{c} (2≤a≤4, 0<b≤2, 2≤c≤5) and may be classified into crystalline lithium silicate and amorphous lithium silicate. The crystalline lithium silicate may be present in the form of at least one lithium silicate selected from the group consisting of Li₂SiO₃, Li₄SiO₄ and Li₂Si₂O₅ in the silicon-containing composite particles, and the amorphous lithium silicate may be in the form of LiₐSi_{b}O_{c} (2≤a≤4, 0<b≤2, 2≤c≤5), and are not limited to the forms.

In an embodiment of the present specification, the Li element may be included in an amount of 0.1 wt% to 20 wt%, or 0.1 wt% to 10 wt% based on total 100 wt% of the silicon-based active material. Specifically, the Li element may be included in an amount of 0.5 wt% to 8 wt%, more specifically 0.5 wt% to 4 wt%. When the above range is satisfied, the Li compound may be included in an appropriate content in the silicon-based active material, so that the volume change of the negative electrode active material during the charging and discharging of a battery may be readily suppressed, and the discharge capacity and initial efficiency of the battery may be improved.

The content of the Mg element or Li element may be confirmed by ICP analysis. For the ICP analysis, after a predetermined amount (about 0.01 g) of the negative electrode active material is exactly aliquoted, the negative electrode active material is completely decomposed on a hot plate by transferring the aliquot to a platinum crucible and adding nitric acid, hydrofluoric acid, or sulfuric acid thereto. Thereafter, a reference calibration curve is prepared by measuring the intensity of a standard liquid prepared using a standard solution (5 mg/kg) in an intrinsic wavelength of the Mg element or Li element using an inductively coupled plasma atomic emission spectrometer (ICPAES, Perkin-Elmer 7300). Thereafter, a pre-treated sample solution and a blank sample are each introduced into the apparatus, an actual intensity is calculated by measuring each intensity, the concentration of each component relative to the prepared calibration curve is calculated, and then the contents of the Mg element or the Li element of the prepared silicon-based active material may be analyzed by converting the total sum so as to be the theoretical value.

In an embodiment of the present specification, a carbon layer may be provided on the surface of the silicon-based composite particles and/or inside pores. By the carbon layer, electrical conductivity is imparted to the silicon-based composite particles, and the initial efficiency, service life characteristics, and battery capacity characteristics of a secondary battery including the negative electrode active material including the silicon-based composite particles may be improved. The total weight of the carbon layer may be included in an amount of 5 wt% to 40 wt% based on total 100 wt% of the silicon-based composite particles.

In an embodiment of the present specification, the carbon layer may include at least any one of amorphous carbon and crystalline carbon.

The silicon-based active material may have an average particle diameter (D₅₀) of 2 um to 15 um, specifically 3 um to 12 µm, and more specifically 4 um to 10 um. When the above range is satisfied, side reactions between the silicon-based composite particles and an electrolyte solution may be controlled, and the discharge capacity and initial efficiency of the battery may be effectively implemented.

In the present specification, an average particle diameter (D₅₀) may be defined as a particle diameter corresponding to 50% of a cumulative volume in a particle diameter distribution curve of the particles. The average particle diameter (D₅₀) may be measured using, for example, a laser diffraction method. The laser diffraction method can generally measure a particle diameter of about several mm from the submicron region, and results with high reproducibility and high resolution may be obtained.

According to an embodiment of the present specification, the negative electrode active material layer may further include an additional negative electrode active material in addition to the above-described silicon-based active material.

As the additional negative electrode active material, a compound capable of reversible intercalation and deintercalation of lithium may be used. Specific examples thereof include a metallic compound alloyable with lithium such as Si, Al, Sn, Pb, Zn, Bi, In, Mg, Ga, Cd, a Si alloy, a Sn alloy, or an Al alloy; a metal oxide which may be undoped and doped with lithium such as SiOβ (0 < β < 2), SnO2, vanadium oxide, lithium titanium oxide, and lithium vanadium oxide; a composite including the metallic compound and the carbonaceous material such as a Si-C composite or a Sn-C composite; or a carbon-based active material, and the like, and any one thereof or a mixture of two or more thereof may be used. Furthermore, a metallic lithium thin film may be used as the negative electrode active material.

In an embodiment of the present invention, a weight ratio of the silicon-based active material and the additional negative electrode active material included in the negative electrode active material layer may be 1:99 to 90:10, specifically 1:99 to 50:50.

In an embodiment of the present specification, the carbon-based active material can be used without any particular limitation, and as a representative example thereof, crystalline carbon, amorphous carbon, or a combination thereof may be used. Examples of the crystalline carbon include graphite such as amorphous, plate, flake, spherical or fibrous natural graphite and artificial graphite, and examples of the amorphous carbon include soft carbon (low temperature calcined carbon), hard carbon, mesophase pitch carbide, fired coke, and the like. The graphite may be natural graphite, artificial graphite or a mixture thereof. Based on 100 parts by weight of the entire negative electrode active material included in the negative electrode active material layer, the carbon-based active material may be included in an amount of 60 parts by weight or more and 99 parts by weight or less.

In an embodiment of the present specification, the negative electrode active material in 100 parts by weight of the negative electrode active material layer may be included in an amount of 80 parts by weight or more and 99.9 parts by weight or less, preferably 90 parts by weight or more and 99.9 parts by weight or less, more preferably 95 parts by weight or more and 99.9 parts by weight or less, and even more preferably 96 parts by weight or more and 99.9 parts by weight or less.

According to an additional embodiment of the present specification, the negative electrode active material layer may further include a negative electrode binder in addition to the silicon-based active material and the carbon-based active material.

The negative electrode binder may serve to improve the bonding between negative electrode active material particles and the adhesion between the negative electrode active material particles and the negative electrode current collector. As the negative electrode binder, those known in the art may be used, and non-limiting examples thereof may include at least one selected from the group consisting of a polyvinylidene fluoride-hexafluoropropylene copolymer (PVDF-co-HFP), polyvinylidene fluoride, polyacrylonitrile, polymethylmethacrylate, polyvinyl alcohol, carboxymethyl cellulose (CMC), starch, hydroxypropyl cellulose, regenerated cellulose, polyvinylpyrrolidone, tetrafluoroethylene, polyethylene, polypropylene, polyacrylic acid, an ethylene-propylene-diene monomer (EPDM), a sulfonated EPDM, styrene butadiene rubber (SBR), fluorine rubber, polyacrylic acid and a material in which the hydrogen thereof is substituted with Li, Na, Ca, or the like, and may also include various copolymers thereof.

The negative electrode binder may be included in an amount of 0.1 parts by weight or more and 20 parts by weight or less, for example, preferably 0.3 parts by weight or more and 20 parts by weight or less, and more preferably 0.5 parts by weight or more and 10 parts by weight or less, based on 100 parts by weight of the negative electrode active material layer.

The negative electrode active material layer may not include a conductive material, but may further include a conductive material, if necessary. The conductive material included in the negative electrode active material layer is not particularly limited as long as the conductive material has electrical conductivity without causing a chemical change to the battery, and for example, it is possible to use graphite such as natural graphite or artificial graphite; carbon black such as acetylene black, Ketjen black, channel black, furnace black, lamp black, and thermal black; a conductive fiber such as carbon fiber or metal fiber; a conductive tube such as a carbon nanotube; a metal powder such as a fluorocarbon powder, an aluminum powder, and a nickel powder; a conductive whisker such as zinc oxide and potassium titanate; a conductive metal oxide such as titanium oxide; a conductive material such as polyphenylene derivatives, and the like. The content of the conductive material in the negative electrode active material layer may be 0.01 parts by weight to 20 parts by weight, preferably 0.03 parts by weight to 18 parts by weight, based on 100 parts by weight of the negative electrode active material layer.

In an embodiment of the present specification, the negative electrode active material layer may have a thickness of 10 um or more and 500 um or less.

In an embodiment, the negative electrode current collector is sufficient as long as the negative electrode current collector has electrical conductivity without causing a chemical change to the battery, and is not particularly limited. For example, as the current collector, it is possible to use copper, stainless steel, aluminum, nickel, titanium, fired carbon, or aluminum or stainless steel whose surface is treated with carbon, nickel, titanium, silver, and the like. Specifically, a transition metal, such as copper or nickel which adsorbs carbon well, may be used as a current collector. Although the current collector may have a thickness of 1 um to 500 µm, the thickness of the current collector is not limited thereto.

The positive electrode and the negative electrode may be manufactured by a typical method for manufacturing a positive electrode and a negative electrode, except that the aforementioned positive electrode and negative electrode active materials are used. Specifically, after a composition for forming an active material layer, which includes the aforementioned active material and, optionally, a binder and a conductive material is applied onto current collectors, the positive electrode and negative electrode may be manufactured by drying and rolling the current collectors. In this case, the types and contents of the positive and negative electrode active materials, binders, and conductive materials are as described above. The solvent may be a solvent commonly used in the art, examples thereof include dimethyl sulfoxide (DMSO), isopropyl alcohol, N-methylpyrrolidone (NMP), acetone, water, or the like, and among them, any one thereof or a mixture of two or more thereof may be used. The amount of solvent used is sufficient as long as the solvent in the amount dissolves or disperses the active material, conductive material and binder in consideration of the application thickness and preparation yield of the composition, and has a viscosity capable of exhibiting excellent thickness uniformity during subsequent application for manufacturing the positive electrode and the negative electrode. Alternatively, by another method, the positive electrode and the negative electrode may be manufactured by casting the composition for forming an active material layer on a separate support and then laminating a film obtained by performing peel-off from the support on a current collector.

In the secondary battery according to an embodiment, the efficiency Ec of the positive electrode may be smaller than the efficiency Ea of the negative electrode. According to one example, the ratio (Ec/Ea) of the efficiency Ec of the positive electrode and the efficiency Ea of the negative electrode is 0.5 to 0.8. As described above, when a lithium-nickel-based oxide on which a coating layer including a specific material is formed is used as a positive electrode active material and a silicon-based active material is used as a negative electrode active material, the efficiency of the positive electrode and the efficiency of the negative electrode may complement the irreversible capacity of the negative electrode by having the aforementioned relationship.

The separator separates the negative electrode and the positive electrode and provides a passage for movement of lithium ions, and can be used without particular limitation as long as the separator is typically used as a separator in a secondary battery, and in particular, a separator having an excellent ability to retain moisture of an electrolyte solution as well as low resistance to ion movement in the electrolyte is preferable. Specifically, it is possible to use a porous polymer film, for example, a porous polymer film formed of a polyolefin-based polymer such as an ethylene homopolymer, a propylene homopolymer, an ethylene/butene copolymer, an ethylene/hexene copolymer, and an ethylene/methacrylate copolymer, or a laminated structure of two or more layers thereof. In addition, a typical porous non-woven fabric, for example, a non-woven fabric made of a glass fiber having a high melting point, a polyethylene terephthalate fiber, and the like may also be used. Furthermore, a coated separator including a ceramic component or a polymeric material may be used to secure heat resistance or mechanical strength and may be selectively used as a single-layered or multi-layered structure.

Examples of the electrolyte include an organic liquid electrolyte, an inorganic liquid electrolyte, a solid polymer electrolyte, a gel-type polymer electrolyte, a solid inorganic electrolyte, a molten-type inorganic electrolyte, and the like, which can be used in the preparation of a lithium secondary battery, but are not limited thereto.

Specifically, the electrolyte may include a non-aqueous organic solvent and a metal salt.

As the non-aqueous organic solvent, it is possible to use, for example, an aprotic organic solvent, such as N-methyl-2-pyrrolidinone, propylene carbonate, ethylene carbonate, butylene carbonate, dimethyl carbonate, diethyl carbonate, γ-butyrolactone, 1,2-dimethoxy ethane, tetrahydrofuran, 2-methyl tetrahydrofuran, dimethyl sulfoxide, 1,3-dioxolane, formamide, dimethylformamide, dioxolane, acetonitrile, nitromethane, methyl formate, methyl acetate, phosphate triester, trimethoxy methane, a dioxolane derivative, sulfolane, methyl sulfolane, 1,3-dimethyl-2-imidazolidinone, a propylene carbonate derivative, a tetrahydrofuran derivative, ether, methyl propionate, and ethyl propionate.

In particular, among the carbonate-based organic solvents, cyclic carbonates ethylene carbonate and propylene carbonate may be preferably used because the cyclic carbonates have high permittivity as organic solvents of a high viscosity and thus dissociate a lithium salt well, and such cyclic carbonates may be more preferably used since the cyclic carbonate may be mixed with a linear carbonate of a low viscosity and low permittivity such as dimethyl carbonate and diethyl carbonate in an appropriate ratio and used to prepare an electrolyte having a high electrical conductivity.

As the metal salt, a lithium salt may be used, the lithium salt is a material which is easily dissolved in the non-aqueous electrolyte solution, and for example, as an anion of the lithium salt, it is possible to use one or more selected from the group consisting of F-, Cl-, I-, NO₃-, N(CN)₂-, BF₄-, ClO₄-, PF₆-, (CF₃)₂PF₄-, (CF₃)₃PF₃-, (CF₃)₄PF₂-, (CF₃)₅PF-, (CF₃)₆P-, CF₃SO₃-, CF₃CF₂SO₃-, (CF₃SO₂)₂N-, (FSO₂)₂N-, CF₃CF₂(CF₃)₂CO-, (CF₃SO₂)₂CH-, (SF₅)₃C-, (CF₃SO₂)₃C-, CF₃(CF₂)₇SO₃-, CF₃CO₂-, CH₃CO₂-, SCN- and (CF₃CF₂SO₂)₂N-.

In the electrolyte, for the purpose of improving the service life characteristics of a battery, suppressing the decrease in battery capacity, and improving the discharge capacity of the battery, one or more additives, such as, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride may be further included in addition to the above electrolyte constituent components.

A secondary battery according to an embodiment of the present invention includes an assembly including a positive electrode, a negative electrode, a separator and an electrolyte, and may be a lithium secondary battery.

An additional embodiment of the present invention provides a battery module including the above-described secondary battery as a unit cell and a battery pack including the same. The battery module and the battery pack include the secondary battery which has high capacity, high rate-limiting properties, and cycle properties, and thus, may be used as a power source of a medium-and-large sized device selected from the group consisting of an electric vehicle, a hybrid electric vehicle, a plug-in hybrid electric vehicle, and a power storage system.

Since the secondary battery according to embodiments of the present invention stably exhibits excellent discharge capacity, output characteristics, and cycle performance, the lithium secondary battery may be used as a power source for portable devices such as mobile phones, notebook-sized computers and digital cameras, and medium-and-large sized devices selected from the group consisting of electric vehicles, hybrid electric vehicles, plug-in hybrid electric vehicles, and power storage systems. For example, the battery module or battery pack may be used as a power source for one or more medium-and-large sized devices of a power tool; an electric vehicle including an electric vehicle (EV), a hybrid electric vehicle and a plug-in hybrid electric vehicle (PHEV); and a power storage system.

Hereinafter, preferred embodiments will be suggested to facilitate understanding of the present invention, but the embodiments are only provided to illustrate the present invention, and it is apparent to those skilled in the art that various alterations and modifications are possible within the scope and technical spirit of the present invention, and it is natural that such alterations and modifications also fall within the accompanying claims.

### Example 1

A precursor with a Ni_{0.84}Co_{0.08}Mn_{0.08}(OH)₂ composition and LiOH were put into a Hensel mixer (700 L) in such an amount that the molar ratio of (Ni+Co+Mn) : Li was 1 : 1.06, and were mixed at a center speed of 400 rpm for 20 minutes. The mixed powder was put into an aluminum crucible having a size of 330 mm x 330 mm and heat-treated at 760°C in an oxygen (O₂) atmosphere for 12 hours to prepare a lithium composite transition metal oxide with a Li_{1.0}Ni_{0.84}Co_{0.08}Mn_{0.08}O₂ composition. Thereafter, the prepared lithium composite transition metal oxide was mixed with water at a ratio of 1:1, and the resulting mixture was stirred for 5 minutes, and dried in a vacuum oven at 130°C for 12 hours to prepare the lithium composite transition metal oxide in the form of single particles. Subsequently, the lithium composite transition metal oxide was dry-mixed with 20,000 ppm of Co(OH)₂ relative to the total weight of the lithium composite transition metal oxide. The mixture was heat-treated at 600°C in an air atmosphere for 6 hours to prepare single particles of a lithium composite transition metal oxide on which a cobalt coating layer was formed. The lithium composite transition metal oxide was dry-mixed with 1200 ppm of H₃BO₃ relative to the total weight of the lithium composite transition metal oxide on which the cobalt coating layer was formed, and then heat-treated at 400°C for 5 hours to prepare a first positive electrode active material on which a boron coating layer was formed. A second positive electrode active material was prepared in the same manner as the first positive electrode active material, except that the firing temperature was 8,00°C and the boron coating content was 600 ppm under the conditions of preparing the first positive electrode active material.

First and second positive electrode active materials, which are single particles of lithium composite transition metal oxides on which a cobalt coating layer and a boron coating layer were provided on a portion of the particle surface, a conductive material (CNT) and a binder (PVDF) were put into a methylpyrrolidone (NMP) solvent at a weight ratio of 97 : 1 : 2 to provide a positive electrode slurry (a positive electrode slurry solid content was included in an amount of 70 parts by weight of the entire positive electrode slurry).

Here, the first positive electrode active material and the second positive electrode active material have D50 of 3 um and 7 um, respectively, as single particles, and the amounts of cobalt and boron are as shown in the following Table 1. The first positive electrode active material and the second positive electrode active material were mixed at a weight ratio of 5:5.

The positive electrode slurry prepared above was applied on an Al current collector, dried at 130°C, and then rolled at room temperature to manufacture a positive electrode.

A negative electrode active material including a SiO-based active material and graphite (SiO-based active material is included in an amount of 5 parts by weight of the entire negative electrode active material), a conductive material (carbon black), a binder (SBR) and a thickener (CMC) were put into a distilled water solvent at a weight ratio of 96 : 1 : 2 : 1 to prepare a negative electrode slurry (the solid content of the negative electrode slurry is included in an amount of 50 parts by weight of the entire negative electrode slurry).

The positive electrode slurry prepared above was applied on a Cu current collector, dried at high temperature, and then rolled at room temperature to manufacture a negative electrode.

A separator was interposed between the positive electrode and the negative electrode manufactured as described above and assembled, and an electrolyte solution was injected, and then activated to manufacture a cell.
- Electrolyte solution composition: 1 M LiPF₆, ethylene carbonate (EC)/ethyl methyl carbonate (EMC) (volume ratio 3/7), vinylene carbonate (VC)/propane sultone (PS) (based on 100 parts by weight of electrolyte) (included in an amount of 3 parts by weight and 1.5 parts by weight, respectively, based on 100 parts by weight of the electrolyte)
- Activation: 0.1 C, 3 hrs. Degas after high temperature/room temperature aging after charging

The electrode density, discharge end resistance, room temperature service life, and high temperature service life of the positive electrode are shown in the following Table 2.

The meanings or measurement methods of electrode density, discharge end resistance, room temperature service life and high temperature service life are as follows.
* Electrode density: (Electrode weight / (Electrode thickness * Electrode area))
   - Electrode weight: Slurry weight except for aluminum foil weight
   - Electrode thickness: Slurry layer thickness except for aluminum foil thickness
* Discharge end resistance: the third discharge capacity was measured (initial capacity) by constant current/constant voltage (CC/CV) charging (0.05 C-cut) and 0.33 C constant current (CC) discharging (2.5 V-cut) the manufactured cell three times to 4.2 V at 0.33 C. Thereafter, after charging as described above, the SOC was set to 5% by discharging at 0.33 C, and pulse discharging was performed at 2 C for 10 seconds to measure the resistance (initial resistance).
* Room temperature service life: cycle was performed by constant current/constant voltage (CC/CV) charging (0.05 C-cut) and 0.5 C constant current (CC) discharging (2.5 V-cut) the manufactured cell to 4.2 V at 0.5 C at room temperature (25°C). After repeating the experiment 100 times, the capacity and resistance were measured in the same manner as in Experimental Example 1 to measure the capacity retention rate (capacity after 100 times/initial capacity x 100%).
* High temperature service life: cycle was performed by constant current/constant voltage (CC/CV) charging (0.05 C-cut) and 1 C constant current (CC) discharging (2.5 V-cut) the manufactured cell to 4.2 V at 1 C at high temperature (45°C). After repeating the experiment 400 times, the capacity and resistance were measured in the same manner as in during the measurement of the discharge end resistance to measure the capacity retention rate (capacity after 100 times/initial capacity x 100%).

### Examples 2 to 10

The same procedure as Example 1 was performed except that the cobalt and boron coating content or average particle diameter (D50) in the first and second positive active materials were changed as shown in Tables 1 to 3 below.

### Comparative Example 1

An experiment was performed in the same manner as in Example 1, except that using the first and second positive electrode active material, water washing before forming the coating layer was not performed and the coating layer including boron was not formed.

### Comparative Example 2

An experiment was performed in the same manner as in Example 1, except that using the first and second positive electrode active material, the coating layer including boron was not formed.

**[Table 1]**

| | Example 1 | Example 2 | Comparative Example 1 | Comparative Example 2 |
|---|---|---|---|---|
| Particle size distribution D50 (µm) (First positive electrode active material/ Second positive electrode active material) (Weight ratio) | 3 µm/ 7 µm (5:5) | 3 µm/ 7 µm (5:5) | 3 µm/ 7 µm (5:5) | 3 µm/ 7 µm (5:5) |
| Water washing | ○ | ○ | X | ○ |
| Cobalt coating layer (First positive | ○ | ○ | | |
| electrode active | (20,000 | (20,000 | ○ | ○ |
| material/ | ppm | ppm | (20,000 ppm | (20,000 ppm |
| Second positive | /20,000 | /20,000 | /20,000 ppm) | /20,000 ppm) |
| electrode active material) | ppm) | ppm) | | |
| Boron coating layer | ○ | ○ | | |
| (First positive | (1200 ppm | (600 ppm | X | X |
| electrode active material/ Second positive electrode active material) | /600 ppm) | /600 ppm) | | |
| B/Co ratio in the coating layers (First positive electrode active material/ Second positive electrode active material) | 0.06/0.03 | 0.03/0.03 | - | - |
| residual lithium by-product (LiOH) (wt%) | 0.38 | 0.32 | 0.25 | 0.26 |
| residual lithium by-product (Li₂CO₃) (wt%) | 0.12 | 0.13 | 0.10 | 0.11 |
| Co:B ratio in positive electrode (Co/B ratio) | 96.7:3.3 (29.30) | 97.8:2.2(4 4.45) | 100:0 | 100:0 |
| Electrode density (g/cc) | 3.55 | 3.55 | 3.55 | 3.55 |
| Discharge end resistance (Ω) | 3.36 | 2.88 | 2.53 | 2.49 |
| Room temperature service life (@100 cycle) (%) | 98.7 | 95.1 | 89.3 | 88.1 |
| High temperature service life (@100 cycle) (%) | 97.3 | 95.5 | 85.7 | 84.8 |

**[Table 2]**

| | Example 3 | Example 4 | Example 5 | Example 6 | Example 7 |
|---|---|---|---|---|---|
| Particle size distribution D50 (µm) (First positive electrode active material/ Second positive electrode active material) (Weight ratio) | 4*µ*m / 5*µ*m (5:5) | 3*µ*m / 7*µ*m (5:5) | 2*µ*m / 4*µ*m (5:5) | 3*µ*m / 4*µ*m (5:5) | 6*µ*m / 10*µ*m (5:5) |
| Water washing | ○ | ○ | ○ | ○ | ○ |
| Cobalt coating | ○ | ○ | ○ | ○ | ○ |
| layer (First positive electrode active material/ Second positive electrode active material) | (20,000 ppm /20,000 ppm) | (10,000 ppm /10,000 ppm) | (20,000 ppm /20,000 ppm) | (20,000 ppm /20,000 ppm) | (20,000 ppm /20,000 ppm) |
| Boron coating layer (First positive electrode active | ○ | ○ | ○ | ○ | ○ |
| material/ Second positive electrode active material) | (1,200 ppm /600ppm) | (1,000 ppm /600ppm) | (1,000 ppm /600ppm) | (1,200 ppm /600ppm) | (800 ppm /500ppm) |
| B/Co ratio in the coating layers (First positive electrode active material/ Second positive electrode active material) | 0.06/0.0 3 | 0.1/0.06 | 0.05/0.0 3 | 0.06/0.0 3 | 0.04/0.0 25 |
| residual lithium by-product (LiOH) (wt%) | 0.39 | 0.36 | 0.39 | 0.41 | 0.35 |
| residual lithium by-product (Li₂CO₃) (wt%) | 0.11 | 0.12 | 0.13 | 0.13 | 0.10 |
| Co:B ratio in positive | 96.7:3.3 | 97.1:2.9 | 97.1:2.9 | 96.7:3.3 | 97.6:2.4 |
| electrode (Co/B ratio) | (29.30) | (33.48) | (33.48) | (29.30) | (40.67) |
| Electrode density (g/cc) | 3.55 | 3.55 | 3.55 | 3.55 | 3.55 |
| Discharge end resistance (Ω) | 2.77 | 3.11 | 2.68 | 2.75 | 2.73 |
| Room temperature service life (@100 cycle) (%) | 94.2 | 94.8 | 93.5 | 94.1 | 93.7 |
| High temperature service life (@100 cycle) (%) | 93.6 | 94.7 | 92.8 | 94.2 | 93.1 |

**[Table 3]**

| | Example 8 | Example 9 | Example 10 | Example 11 | Example 12 |
|---|---|---|---|---|---|
| Particle size distribution D50 (µm) (First positive electrode active material/ Second positive electrode active material) (Weight ratio) | 3*µ*m / 7*µ*m (5:5) | 3*µ*m / 7*µ*m (5:5) | 3*µ*m / 7*µ*m (5:5) | 3*µ*m / 7*µ*m (5:5) | 3*µ*m / 7*µ*m (5:5) |
| Water washing | ○ | ○ | ○ | ○ | ○ |
| Cobalt coating layer (First | ○ | ○ | ○ | ○ | ○ |
| positive electrode active material/ Second positive electrode active material) | (20,000 ppm /20,000 ppm) | (20,000 ppm /20,000 ppm) | (20,000 ppm /20,000 ppm) | (2,000 ppm /2,000 ppm) | (60,000 ppm /60,000 ppm) |
| Boron coating layer (First positive | ○ | ○ | ○ | ○ | ○ |
| electrode active material/ Second positive electrode active material) | (600 ppm /1,000ppm ) | (100 ppm /1,000ppm ) | (3,500 ppm /3,500ppm ) | (1,200 ppm /600ppm) | (1,200 ppm /600ppm) |
| B/Co ratio in the coating layers (First positive electrode active material/ Second positive electrode active material) | 0.03/0.05 | 0.005/0.0 5 | 0.175/0.1 75 | 0.6/0.3 | 0.02/0.01 |
| residual lithium by-product (LiOH) (wt%) | 0.34 | 0.28 | 0.44 | 0.37 | 0.39 |
| residual lithium bv-product (Li₂CO₃) (wt%) | 0.12 | 0.11 | 0.16 | 0.12 | 0.13 |
| Co:B ratio in positive | 97.1:2.9 | 98.0:2.0 | 88.4:11.6 | 96.7:3.3 | 96.7:3.3 |
| electrode (Co/B ratio) | (33.48) | (49.00) | (7.62) | (29.30) | (29.30) |
| Electrode density (g/cc) | 3.55 | 3.55 | 3.55 | 3.55 | 3.55 |
| Discharge end resistance (Ω) | 3.07 | 2.64 | 3.41 | 3.40 | 3.45 |
| Room temperature service life (@100 cycle) (%) | 94.5 | 92.8 | 92.9 | 91.7 | 90.6 |
| High temperature service life (@100 cycle) (%) | 94.4 | 91.7 | 90.9 | 88.9 | 87.6 |

As shown in Tables 1 to 3, it could be confirmed that in the case of Examples, the discharge end resistance was higher, and the service life at room temperature and the service life at high temperature were better than in Comparative Examples 1 and 2. In particular, in the case of Example 1, compared to Examples 2, 8, and 9, the first positive electrode active material contained higher boron content, so discharge end resistance was excellent and room temperature and high temperature service life characteristics were higher. In the case of Examples 1, 2, and 8, the average particle size was larger compared to Examples 3, 5, and 6, so the discharge end resistance was relatively larger, and as a result, room temperature and high temperature service life characteristics were superior. Examples 1, 2, and 8 showed better room temperature and high temperature service life characteristics compared to Examples 9 and 10 due to the appropriate B content. In the case of Examples 1 to 10, compared to Examples 11 and 12, room temperature and high temperature service life characteristics were excellent due to the appropriate Co content.

The content of the residual lithium by-product was measured through pH titration. Since the pH range where the residual lithium by-product and LBO (lithium borate oxide) are titrated are similar, the examples include the amount of LBO by B coating in the LiOH value. However, Comparative Examples 1 and 2 did not form a B coating layer, and therefore there was no LBO phase, so the content of residual lithium by-product was measured to be relatively low.

## Claims

1. A positive electrode material comprising: a first positive electrode active material which is in the form of single particles presenting an average particle diameter (D50) D1 and has a coating layer comprising cobalt (Co) and boron (B) provided on at least a portion of the surface of the single particles; and
a second positive electrode active material which is in the form of single particles presenting an average particle diameter D2 , with D2>D1, and has a coating layer comprising cobalt (Co) and boron (B) provided on at least a portion of the surface of the single particles.

2. The positive electrode material according to claim 1, wherein the first positive electrode active material has a D50 of 1 um or more and 7 um or less, and the second positive electrode active material has a D50 of 3 um or more and 13 um or less.

3. The positive electrode material according to claim 1 or 2, wherein the difference D2-D1 between the second positive electrode active material and the first positive electrode active material is 0.5 um to 7 um.

4. The positive electrode material according to any of claims 1 to 3, wherein in each of the first and second positive electrode active materials, the ratio of the amount of boron to the amount of cobalt in the coating layer is 0.001 to 1.

5. The positive electrode material according to any of claims 1 to 4, wherein the ratio of the cobalt content to the boron content contained in the entire first and second positive electrode active materials is 5 to 70.

6. The positive electrode material according to any of claims 1 to 5, wherein each of the coating layer in the first and second positive electrode active materials comprises a coating layer comprising cobalt (Co) and a coating layer comprising boron (B), and the coating layer comprising cobalt (Co) is provided on at least a portion of the surface of the first or second positive electrode active materials or between the coating layer comprising boron (B) and at least a portion of the surface of the first or second positive electrode active materials.

7. The positive electrode material according to any one of claims 1 to 6, wherein the first positive electrode active material comprises cobalt in an amount of 5,000 ppm to 50,000 ppm of the total weight of the first positive electrode active material.

8. The positive electrode material according to any one of claims 1 to 7, wherein the second positive electrode active material comprises cobalt in an amount of 5,000 ppm to 50,000 ppm of the total weight of the second positive electrode active material.

9. The positive electrode material according to any one of claims 1 to 8, wherein a content of boron in the first positive electrode active material is higher than a content of boron in the second positive electrode active material.

10. The positive electrode material according to any one of claims 1 to 9, wherein a weight ratio (A/B) of the content A of boron in the first positive electrode active material and the content B of boron in the second positive electrode active material is 1 to 3.

11. The positive electrode material according to any one of claims 1 to 10, wherein each of the first and second positive electrode active materials comprises boron in an amount of 200 ppm to 3,000 ppm.

12. The positive electrode material according to any one of claims 1 to 11, wherein the first and second positive electrode active materials are a lithium-nickel-based oxides in which a molar ratio of nickel in the metal elements except for lithium is 50 mol% or more.

13. The positive electrode material according to claim 12, wherein the lithium-nickel-based oxide has a composition represented by the following [Chemical Formula 1] :
[Chemical Formula 1] Li₁₊ₓ(NiₐCo_{b}Mn_{c}M_{d})O₂
in Chemical Formula 1,
M is one or more selected from the group consisting of W, Cu, Fe, V, Cr, Ti, Zr, Zn, Al, In, Ta, Y, La, Sr, Ga, Sc, Gd, Sm, Ca, Ce, Nb, Mg, B and Mo, and
x, a, b, c and d are 0≤x≤0.2, 0.50≤a<1, 0<b≤0.25, 0<c≤0.25, 0≤d≤0.1, and a+b+c+d=1, respectively.

14. The positive electrode material according to any one of claims 1 to 13, wherein a weight ratio of the first positive electrode active material and the second positive electrode active material is 9 : 1 to 1 : 9.

15. The positive electrode material according to any one of claims 1 to 14, wherein each of the first positive electrode active material and the second positive electrode active material has a residual lithium by-product content of 1 wt% or less based on 100 wt% of the positive electrode active material.

16. A positive electrode for a secondary battery, comprising: a current collector; and a positive electrode active material layer provided on the current collector and comprising the positive electrode material according to any one of claims 1 to 15.

17. A secondary battery comprising the positive electrode according to claim 16, a negative electrode and a separator.

18. The secondary battery of claim 17, wherein the negative electrode comprises a silicon-based active material.

19. The secondary battery of claim 18, wherein the negative electrode further comprises a carbon-based active material.

20. The secondary battery according to any one of claims 17 to 19, wherein an efficiency Ec of the positive electrode is smaller than an efficiency Ea of the negative electrode.

21. A method for preparing the positive electrode material according to any one of claims 1 to 15, the method comprising:
preparing a first positive electrode active material, including: forming a first positive electrode active material in the form of single particles by mixing a transition metal precursor and a lithium raw material, and then firing the resulting mixture;
optionally washing the positive electrode active material with water; and
forming a coating layer comprising cobalt (Co) and boron (B) on at least a portion of the surface of the positive electrode active material;
preparing a second positive electrode active material, comprising: forming a second positive electrode active material in the form of single particles having a larger particle diameter than that of the single particles of the first positive electrode active material by mixing a transition metal precursor and a lithium raw material, and then firing the resulting mixture;
optionally washing the positive electrode active material with water; and
forming a coating layer including cobalt (Co) and boron (B) on at least a portion of the surface of the positive electrode active material; and
mixing the first positive electrode active material and the second positive electrode active material.

22. The method of claim 21, wherein the forming a coating layer comprising cobalt (Co) and boron (B) on at least a portion of the surface of the positive electrode active material comprises the following successive steps:
forming the coating layer comprising cobalt (Co); and
forming the coating layer comprising boron (B).
